# EUROPEAN PATENT APPLICATION

(11) **EP 4 654 333 A1**
(43) Date of publication of application: **26.11.2025**
(21) Application number: 25153692.6
(22) Date of filing: 24.01.2025
(51) Int. Cl.: H01M 10/613, H01M 10/6556, F28F 27/02, H01M 10/6567, F28F 9/02, H01M 50/00, F16K 15/04, F16K 15/14

(54) **LIQUID COOLING PLATE STRUCTURE AND BATTERY PACK**

(30) Priority: 23.05.2024 CN 202421151532 U; 11.07.2024 WO PCT/CN2024/104975
(71) Applicant: Eve Energy Storage Co., Ltd, Wuhan, Hubei 430074 (CN)
(72) Inventor: LI, Guotao, Wuhan, Hubei 430074 (CN); FENG, Zhaojun, Wuhan, Hubei 430074 (CN)
(74) Representative: Berggren Oy

(57) **Abstract**

The present disclosure relates to a liquid cooling plate structure and a battery pack. The liquid cooling plate structure includes a liquid cooling plate body (1) provided with a liquid cooling chamber (11), a liquid inlet (12) and a liquid outlet (13) communicating with the liquid cooling chamber (11); a liquid inlet connector (2) detachably disposed at the liquid inlet (12); and a liquid outlet connector (3) detachably disposed at the liquid outlet (13); and at least one of the liquid outlet connector (2) and the liquid inlet connector (3) is provided with a check member (7). In the present disclosure, a new liquid cooling plate can be replaced without disassembling the whole battery pack, and backflow can be prevented.

## Description

### TECHNICAL FIELD

The present disclosure relates to the field of batteries, and in particular, to a liquid cooling plate structure and a battery pack.

### BACKGROUND

In the related art, water inlet and outlet connectors provided on a liquid cooling plate are integrated with the liquid cooling plate.

The water inlet and outlet connectors protrude from the liquid cooling plate. After the battery pack is assembled, it is very easy to break the water inlet and outlet connectors during installation and transportation. In a case that the water inlet and outlet connectors need to be replaced, the whole battery pack need to be removed, and a new liquid cooling plate need to be installed, which is very troublesome. Moreover, it is found in actual use that backflow problems will occur at the water inlet and outlet connectors, which greatly affects the overall cooling effect.

### SUMMARY

In a first aspect, the present disclosure provides a liquid cooling plate structure, which includes:
a liquid cooling plate body provided with a liquid cooling chamber, a liquid inlet and a liquid outlet communicating with the liquid cooling chamber (11);
a liquid inlet connector detachably disposed at the liquid inlet; and
a liquid outlet connector detachably disposed at the liquid outlet; and at least one of the liquid outlet connector and the liquid inlet connector is provided with a check member.

In some embodiments of the present disclosure, the liquid inlet connector penetrates into the liquid inlet and is in threaded connection with a wall surface of the liquid inlet; and the liquid outlet connector penetrates into the liquid outlet and is in threaded connection with a wall surface of the liquid outlet.

In a second aspect, the present disclosure provides a battery pack including a liquid cooling plate structure as described above.

According to the liquid cooling plate structure provided in the present disclosure, a structure in which the liquid inlet connector and the liquid outlet connector are detachable is specifically adopted. That is, the liquid cooling plate body is detachably connected with the liquid inlet connector, and the liquid cooling plate body is detachably connected with the liquid outlet connector. In this way, the liquid inlet connector and the liquid outlet connector can be removed directly and replaced during subsequent maintenance and replacement, and a new liquid cooling plate can be replaced without disassembling the whole battery pack. The operation is very convenient and quick, and the maintenance cost can be saved. Furthermore, the liquid inlet connector and the liquid outlet connector are designed separately, so that they can be processed separately, which can also reduce the manufacturing difficulty and improve the manufacturing efficiency. Meanwhile, a check member is also specifically provided in both the liquid outlet connector and the liquid inlet connector, so that backflow can be prevented, thus ensuring that the cooling liquid can be normally circulated, and improving the cooling effect.

### DESCRIPTION OF THE DRAWINGS

FIG. 1 is a schematic structural diagram of a liquid cooling plate structure according to some embodiments of the present disclosure.
FIG. 2 is a schematic structural diagram of a liquid cooling plate structure in an exploded state according to some embodiments of the present disclosure.
FIG. 3 is a partially enlarged view at A in FIG. 2.
FIG. 4 is a cross-sectional view of an inner structure of a liquid cooling plate structure according to some embodiments of the present disclosure.
FIG. 5 is another cross-sectional view of an inner structure of a liquid cooling plate structure according to some embodiments of the present disclosure.
FIG. 6 is a cross-sectional view of a liquid inlet connector in a liquid cooling plate structure according to some embodiments of the present disclosure.
FIG. 7 is a partially enlarged view at B in FIG. 6.
FIG. 8 is a schematic view of the internal structure assembled by the liquid outlet connector and the check member in the liquid cooling plate structure according to some embodiments of the present disclosure.

List of reference numbers:
1. a liquid cooling plate; 11. a liquid cooling chamber; 12. a liquid inlet; 13. a liquid outlet; 14. a main rib; 15. a separating rib; 16. a reinforcing rib; 2. a liquid inlet connector; 3. a liquid outlet connector; 4. a threaded section; 5. a fixing ring; 6. a non-threaded section; 7. a check member; 8. a sealing ring.

### DETAILED DESCRIPTION

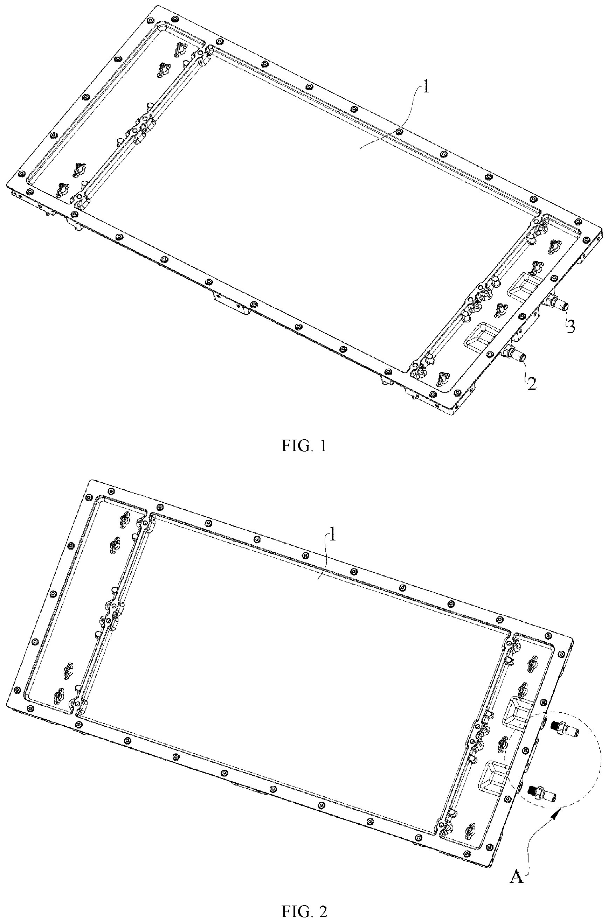

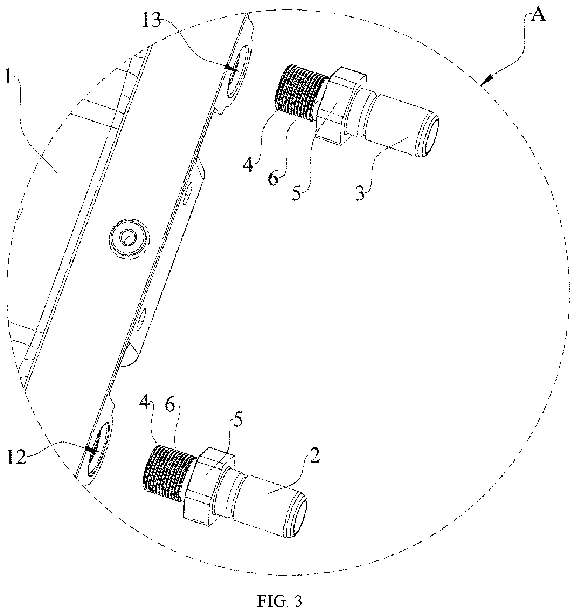

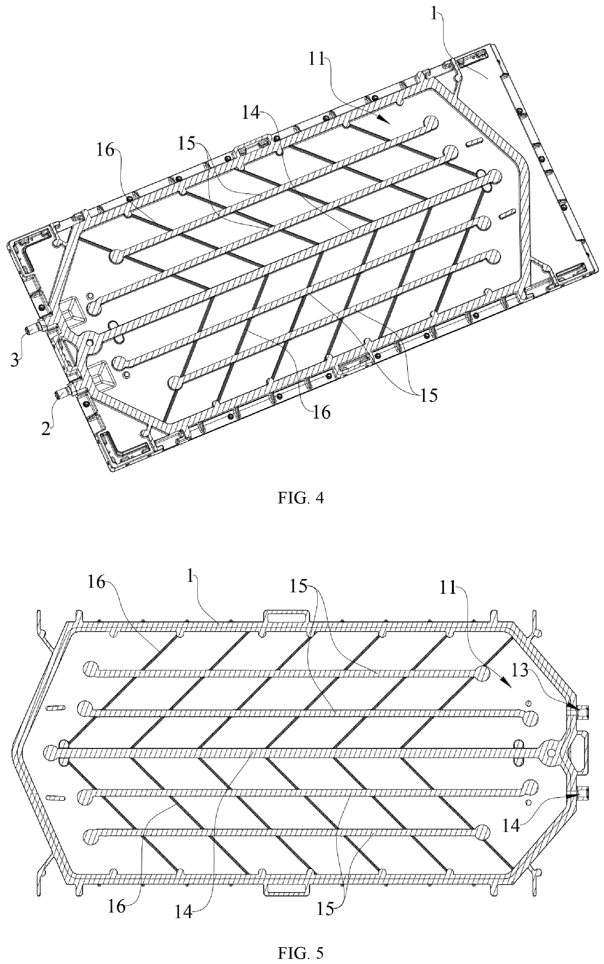

Embodiments of the present disclosure discloses a liquid cooling plate structure. Referring to FIGs. 1 to 7, the liquid cooling plate structure includes a liquid cooling plate body 1, wherein a liquid cooling chamber 11, a liquid inlet 12 and a liquid outlet 13 are disposed therein. Both the liquid inlet 12 and the liquid outlet 13 are communicated with the liquid cooling chamber 11.

The liquid cooling plate structure further includes a liquid inlet conncetor 2, which is detachably disposed at the liquid inlet 12. Optionally, the detachable liquid inlet conncetor 2 may be in a threaded connection, a plug-in connection, a snap-in connection, or the like with the liquid inlet 12.

The liquid cooling plate structure further includes a liquid outlet conncetor 3, which is detachably disposed at the liquid outlet 13. Optionally, the detachable liquid outlet conncetor 3 may in a threaded connection, a plug-in connection, a snap-in connection, or the like with the liquid outlet 13.

Furthermore, at least one of the liquid outlet connector 3 and the liquid inlet connector 2 is provided with a check member 7. Optionally, the check member 7 may be a one-way valve or a check rubber ball.

In the embodiments of the present disclosure, the liquid cooling plate structure adopts a structure in which the liquid inlet connector 2 and the liquid outlet connector 3 are detachable. That is, the liquid cooling plate body 1 is detachably connected with the liquid inlet connector 2, and the liquid cooling plate body 2 is detachably connected with the liquid outlet connector 3. In this way, the liquid inlet connector 2 and the liquid outlet connector 3 can be removed directly and replaced during subsequent maintenance and replacement, and a new liquid cooling plate can be replaced without disassembling the whole battery pack. The operation is very convenient and quick, and the maintenance cost can be saved. Furthermore, the liquid inlet connector 2 and the liquid outlet connector 3 are designed separately, so that they can be processed separately, which can also reduce the manufacturing difficulty and improve the manufacturing efficiency. Meanwhile, a check member 7 is also specifically provided in both the liquid outlet connector 2 and the liquid inlet connector 3, so that backflow can be prevented, thus ensuring that the cooling liquid can be normally circulated, and improving the cooling effect.

Optionally, both the liquid outlet connector 3 and the liquid inlet connector 2 are provided with a check member 7, which can simultaneously prevent backflow.

The check member 7 is a check rubber ball. The check rubber ball in the liquid outlet connector 3 is disposed on one side of the liquid outlet connector 3 close to the liquid outlet 13. The check rubber ball in the liquid inlet connector 2 is disposed on one side of the liquid inlet connector 2 close to the liquid inlet 12.

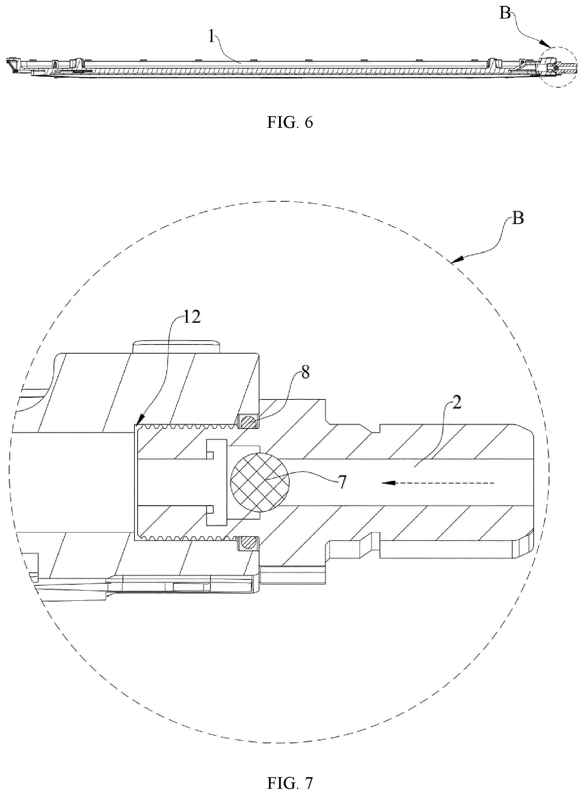

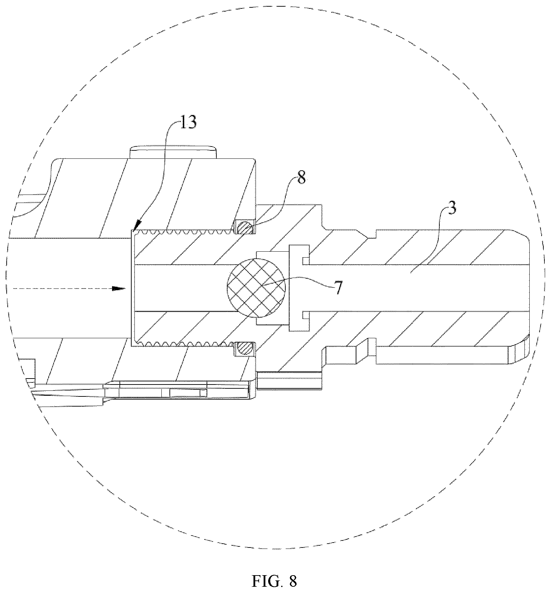

Referring to FIG. 7, the structure of the check rubber ball inside the liquid inlet connector 2 is shown, which can realize one-way liquid inlet. In a case that backflow occurs, the check rubber ball inside the liquid inlet connector 2 will block the flow channel to realize a check. Similarly, referring to FIG. 8, the structure of the check rubber ball inside the liquid outlet connector 3 is shown, which can realize one-way liquid outlet. In a case that backflow occurs, the check rubber ball inside the liquid outlet connector 3 will block the flow channel to realize a check.

Optionally, the liquid inlet connector 2 penetrates into the liquid inlet 12 and is in threaded connection with a wall surface of the liquid inlet 12. The liquid outlet connector 3 penetrates into the liquid outlet 13 and is in threaded connection with a wall surface of the liquid outlet 13. In this embodiment, the detachable connection between the liquid inlet connector 2 and the liquid cooling plate body 1, and the detachable connection between the liquid outlet connector 3 and the liquid cooling plate body 1 may be a threaded connection. The threaded connection structure is simple, which is convenient for manufacturing, and the manufacturing difficulty is reduced.

One end of the liquid inlet connector 2 penetrates into the liquid inlet 12 and is in threaded connection with a wall surface of the liquid inlet 12. The other end of the liquid inlet connector 2 is connected with an external liquid inlet cooling pipeline. One end of the liquid outlet connector 3 penetrates into the liquid outlet 13 and is in threaded connection with a wall surface of the liquid outlet 13. The other end of the liquid outlet connector 3 is connected with an external liquid outlet cooling pipeline. In this way, a cooling fluid circulation is formed in the liquid cooling plate structure, so as to dissipate heat from the battery.

Of course, in other optional embodiments, the liquid inlet connector and the liquid outlet connector are respectively connected with the corresponding liquid inlet and liquid outlet via a snap connection.

Optionally, each of the liquid inlet connector 2 and the liquid outlet connector 3 includes a threaded section 4, a fixing ring 5 and a sealing ring 8. An area between the fixing ring 5 and the threaded section 4 of the liquid inlet connector 2 is a non-threaded section 6, and an area between the fixing ring 5 and the threaded section 4 of the liquid outlet connector 3 is a non-threaded section 6. The sealing ring 8 of the liquid inlet connector 2 is assembled on the non-threaded section 6 of the liquid inlet connector 2. The sealing ring 8 of the liquid outlet connector 3 is assembled on the non-threaded section 6 of the liquid outlet connector 3. In this embodiment, since both the liquid inlet connector 2 and the liquid outlet connector 3 are detachably connected to the liquid cooling plate body 1, the sealing performance will be weakened to a certain extent, so the sealing performance of the connector is improved by providing the sealing ring 8. In specific use, when both the liquid inlet connector 2 and the liquid outlet connector 3 are assembled on the liquid cooling plate body 1, each of the liquid inlet connector 2 and the liquid outlet connector 3 tightly press the sealing ring 8 together with the liquid cooling plate body 1 to improve the sealing performance of the connector and prevent water leakage. Furthermore, the sealing ring 8 is also assembled on the non-threaded section 6, so as to avoid the problem that the threaded section 4 fails to seal the sealing ring 8.

For the liquid inlet connector 2, the sealing ring 8 of the liquid inlet connector 2 can be pressed tightly between a circumferential outer wall of the non-threaded section 6 of the liquid inlet connector 2 and an inner wall of the liquid inlet 12. For the liquid outlet connector 3, the sealing ring 8 of the liquid outlet connector 3 can be pressed tightly between a circumferential outer wall of the non-threaded section 6 of the liquid outlet connector 3 and an inner wall of the liquid outlet 13.

Of course, in other embodiments, the seal ring may be compressed by a fixing ring. For example, the sealing ring on the liquid inlet connector may be compressed between the fixing ring on the liquid inlet connector and a side frame of the liquid cooling plate body. For another example, the sealing ring on the outlet connector may be pressed between the fixing ring on the outlet connector and a side frame of the liquid cooling plate body.

Optionally, the liquid inlet 12 and the liquid outlet 13 are disposed on the same side of the liquid cooling plate body 1. In specific use, it will be more convenient and quick to disassemble and assemble the liquid inlet connector 2 and the liquid outlet connector 3.

Optionally, openings of both the liquid inlet 12 and the liquid outlet 13 are disposed flush with a side frame of the liquid cooling plate body 1. In the specific design, in order to better protect the structures of the liquid inlet 12 and the liquid outlet 13 themselves, the liquid inlet 12 and the liquid outlet 13 themselves will be disposed flush with the side frame of the liquid cooling plate body 1, and will not protrude from the side frame of the liquid cooling plate body 1, in this way, it is not easy to cause deformation of the liquid inlet 12 and the liquid outlet 13 themselves, and the structural strength of the liquid inlet 12 and the liquid outlet 13 themselves can be effectively enhanced.

Optionally, a main rib 14 is disposed in the liquid cooling plate body 1, and the main rib 14 extends along a length direction of the liquid cooling plate body 1. The main rib 14 divides the liquid cooling chamber 11 into a liquid inlet channel communicating with the liquid inlet 12 and a liquid outlet channel communicating with the liquid outlet 13, and the liquid inlet channel communicates with the liquid outlet channel. In this embodiment, a main rib 14 is disposed in the liquid cooling plate body 1 to divide the liquid cooling chamber 11 into a liquid inlet channel and a liquid outlet channel, so as to guide the flow direction of the cooling liquid and to better cool the battery.

Optionally, the liquid cooling chamber 11 has a U-shaped shape as a whole. In this way, the structure is simple, which is convenient for manufacturing and production, and the manufacturing difficulty is reduced.

Optionally, a plurality of separating ribs 15 are disposed in the liquid cooling plate body 1, and the plurality of separating ribs 15 extend along the length direction of the liquid cooling plate body 1. At least one separating rib 15 is disposed in any one or a combination of two of the liquid inlet channel and the liquid outlet channel. In this embodiment, by disposing the separating ribs 15 in the liquid inlet channel and disposing the separating ribs 15 in the liquid outlet channel, it is possible to disperse and flow the cooling liquid in the liquid inlet channel and the liquid outlet channel, so that the area where the cooling liquid flows is larger, and then a larger area of cooling is realized, thereby improving the cooling effect.

Optionally, a plurality of reinforcing ribs 16 are disposed on chamber walls of the liquid inlet channel, a plurality of reinforcing ribs 16 are disposed on chamber walls of the liquid outlet channel, and the plurality of reinforcing ribs 16 disposed on chamber walls of the liquid inlet channel and the plurality of reinforcing ribs 16 disposed on chamber walls of the liquid outlet channel extend in a direction inclined to the length direction of the liquid cooling plate body 1. In this embodiment, by disposing the reinforcing ribs 16 in the liquid inlet channel and the liquid outlet channel, the structural strength of the liquid cooling plate body 1 is enhanced, and the service life is prolonged.

Optionally, the plurality of reinforcing ribs 16 in the liquid inlet channel and the plurality of reinforcing ribs 16 in the liquid outlet channel are symmetrically disposed one by one relative to the main rib 14, so that the structure is simple, which is convenient for manufacturing, and the manufacturing difficulty is reduced.

Some embodiments of the present disclosure further discloses a battery pack including the above-described liquid cooling plate structure. The battery pack also has a structure in which the liquid inlet connector 2 and the liquid outlet connector 3 are detachable. That is, the liquid cooling plate body 1 is detachably connected with the liquid inlet connector 2, and the liquid cooling plate body 1 is detachably connected with the liquid outlet connector 3. In this way, the liquid inlet connector and the liquid outlet connector can be removed directly and replaced during subsequent maintenance and replacement, and a new liquid cooling plate can be replaced without disassembling the whole battery pack. The operation is very convenient and quick, and the maintenance cost can be saved. Furthermore, the liquid inlet connector 2 and the liquid outlet connector 3 are designed separately, so that they can be processed separately, which can also reduce the manufacturing difficulty and improve the manufacturing efficiency.

## Claims

1. A liquid cooling plate structure, **characterized in that** the liquid cooling plate structure comprises:
a liquid cooling plate body (1) provided with a liquid cooling chamber (11), a liquid inlet (12) and a liquid outlet (13) communicating with the liquid cooling chamber (11);
a liquid inlet connector (2) detachably disposed at the liquid inlet (12); and
a liquid outlet connector (3) detachably disposed at the liquid outlet (13); and at least one of the liquid outlet connector (3) and the liquid inlet connector (2) is provided with a check member (7).

2. The liquid cooling plate structure according to claim 1, **characterized in that** the liquid inlet connector (2) penetrates into the liquid inlet (12) and is in threaded connection with a wall surface of the liquid inlet (12); and the liquid outlet connector (3) penetrates into the liquid outlet (13) and is in threaded connection with a wall surface of the liquid outlet (13).

3. The liquid cooling plate structure according to claim 2, **characterized in that** each of the liquid inlet connector (2) and the liquid outlet connector (3) comprises a threaded section (4), a fixing ring (5) and a sealing ring (8), each of an area between the fixing ring (5) and the threaded section (4) of the liquid inlet connector (2) and an area between the fixing ring (5) and the threaded section (4) of the liquid outlet connector (3) is a non-threaded section (6), the sealing ring (8) of the liquid inlet connector (2) is assembled on the non-threaded section (6) of the liquid inlet connector (2), and the sealing ring (8) of the liquid outlet connector (3) is assembled on the non-threaded section (6) of the liquid outlet connector (3).

4. The liquid cooling plate structure according to claim 3, **characterized in that** the sealing ring (8) of the liquid inlet connector (2) is pressed tightly between a circumferential outer wall of the non-threaded section (6) of the liquid inlet connector (2) and an inner wall of the liquid inlet (12).

5. The liquid cooling plate structure according to claim 3, **characterized in that** the sealing ring (8) of the liquid outlet connector (3) is pressed tightly between a circumferential outer wall of the non-threaded section (6) of the liquid outlet connector (3) and an inner wall of the liquid outlet (13).

6. The liquid cooling plate structure according to any one of claims 1 to 5, **characterized in that** the liquid inlet (12) and the liquid outlet (13) are disposed on a same side of the liquid cooling plate body (1).

7. The liquid cooling plate structure according to any one of claims 1 to 6, **characterized in that** openings of both the liquid inlet (12) and the liquid outlet (13) are disposed flush with a side frame of the liquid cooling plate body (1).

8. The liquid cooling plate structure according to any one of claims 1 to 6, **characterized in that** a main rib (14) is disposed in the liquid cooling plate body (1), and the main rib (14) extends along a length direction of the liquid cooling plate body (1); and
wherein the main rib (14) divides the liquid cooling chamber (11) into a liquid inlet channel communicating with the liquid inlet (12) and a liquid outlet channel communicating with the liquid outlet (13), and the liquid inlet channel communicates with the liquid outlet channel.

9. The liquid cooling plate structure according to claim 8, **characterized in that** the liquid cooling chamber has a U-shaped shape as a whole.

10. The liquid cooling plate structure according to claim 8, **characterized in that** a plurality of separating ribs (15) are disposed in the liquid cooling plate body (1), and the plurality of separating ribs (15) extend along the length direction of the liquid cooling plate body (1); and
wherein at least one separating rib (15) is disposed in any one or a combination of two of the liquid inlet channel and the liquid outlet channel.

11. The liquid cooling plate structure according to claim 8, **characterized in that** a plurality of reinforcing ribs (16) are disposed on chamber walls of the liquid inlet channel, a plurality of reinforcing ribs (16) are disposed on chamber walls of the liquid outlet channel, and the plurality of reinforcing ribs (16) disposed on chamber walls of the liquid inlet channel and the plurality of reinforcing ribs (16) disposed on chamber walls of the liquid outlet channel extend in a direction inclined to the length direction of the liquid cooling plate body (1).

12. The liquid cooling plate structure according to claim 11, **characterized in that** the plurality of reinforcing ribs (16) in the liquid inlet channel and the plurality of reinforcing ribs (16) in the liquid outlet channel are symmetrically disposed one by one relative to the main rib (14).

13. The liquid cooling plate structure according to any one of claims 1 to 6, **characterized in that** each of the outlet connector (3) and the inlet connector (2) is provided with a check member (7), and the check member (7) is a check rubber ball;
the check rubber ball in the liquid outlet connector (3) is disposed on one side of the liquid outlet connector (3) close to the liquid outlet (13); and
the check rubber ball in the liquid inlet connector (2) is disposed on one side of the liquid inlet connector (2) close to the liquid inlet (12).

14. The liquid cooling plate structure according to any one of claims 1 to 13, **characterized in that** the detachable liquid inlet conncetor (2) is in a threaded connection, a plug-in connection, or a snap-in connection with the liquid inlet (12); or the detachable liquid outlet connector (3) is in a threaded connection, a plug-in connection, or a snap-in connection with the liquid outlet (13); or the detachable liquid inlet conncetor (2) is in a threaded connection, a plug-in connection, or a snap-in connection with the liquid inlet (12), and the detachable liquid outlet connector (3) is in a threaded connection, a plug-in connection, or a snap-in connection with the liquid outlet (13).

15. A battery pack, **characterized in that** the battery pack comprises the liquid cooling plate structure according to any one of claims 1 to 14.
